# EUROPEAN PATENT APPLICATION

(11) **EP 2 065 941 A2**
(43) Date of publication of application: **03.06.2009**
(21) Application number: 08253855.4
(22) Date of filing: 01.12.2008
(51) Int. Cl.: H01L 31/0224, H01L 31/075, H01L 31/0376

(54) **Solar cell and a manufacturing method of the solar cell**

(30) Priority: 30.11.2007 JP 2007311586
(71) Applicant: SANYO Electric Co., Ltd., Moriguchi-shi Osaka 570-8677 (JP)
(72) Inventor: Kinoshita, Toshihiro , Sanyo Electric Co., Ltd., Osaka 570-8677 (JP)
(74) Representative: Calderbank, Thomas Roger

(57) **Abstract**

The manufacturing method of the solar cell according to the present invention includes: 1) a first etching process in which an anisotropic etching is performed on an inner wall of each of a plurality of through holes, and 2) a second etching process in which an anisotropic etching is performed on a light-receiving surface. In the first etching process, a high concentration NaOH water solution (about 5% by weight) is used. Meanwhile, in the second etching process, a low concentration (about 1.5% by weight) NaOH water solution is used.

## Description

This application is based upon and claims the benefit of priority from prior Japanese Patent Application No. 2007-311586, filed on November 30, 2007; the entire contents of which are incorporated herein by reference.

The present invention relates to a solar cell provided with a through hole electrode, and a manufacturing method of such solar cell.

A solar cell can directly convert the clean and inexhaustibly supplied sunlight to electricity, and thus is expected as a new energy source.

Conventionally, for a purpose of increasing the light-receiving surface area of the solar cell, a back contact type solar cell has been proposed in which both a p-side electrode and an n-side electrode are provided on the back-surface-side of the substrate (for example, Japanese Unexamined Patent Application Publication No. Hei 1-82570).

Such a solar cell has a plurality of through holes each penetrating the substrate from the light-receiving surface to the back surface. Photogenerated carriers collected on the light-receiving surface side of the substrate are conducted via a through hole electrode provided in a through hole to the back surface side of the solar cell. An insulating layer is formed on the inner wall surface of the through hole to prevent occurrence of a short circuit between the inner wall surface of the through hole and the through hole electrode.

The through hole is formed by a laser processing or a mechanical processing, and consequently causes damages on its inner wall surface. To improve the output characteristics of the solar cell, it is preferable that the damage on the inner wall surface of the through hole is removed by an etching processing.

Meanwhile, for the purpose of improving the output characteristics of the solar cell, a relief structure, i.e., a so-called textured structure, is usually formed on the light-receiving surface of the solar cell. In general, such a textured structure is formed by an etching processing.

Here, the damage on the inner wall surface of the through hole can be removed by performing an etching processing on the inner wall surface simultaneously with performing an etching processing on the light-receiving surface for forming the textured structure after the formation of the through hole.

However, when the inner wall surface of the through hole is etched in the etching process to form the textured structure, a relief structure is also formed on the inner wall surface of the through hole. When an insulating layer is formed on such an inner wall surface of the through hole, the insulating layer is formed with uneven thickness. Therefore, the insulating layer at a portion with small thickness does not sufficiently insulate the inner wall surface of the through hole and the through hole electrode from each other, and therefore a short circuit is more likely to occur between the substrate and the through hole electrode. As a result, there has been a problem that the output characteristics of the solar cell are deteriorated.

A first aspect of the present invention is summarized as a solar cell including a semiconductor substrate having a first conductive type and including a first main surface and a second main surface; a semiconductor region having a second conductive type and provided on the first main surface of the semiconductor substrate; a plurality of through holes each provided in a plurality of portions in the semiconductor substrate and each penetrating from the first main surface to the second main surface; a plurality of through hole electrodes each provided in each of the plurality of through holes and each conducting photogenerated carriers collected in the semiconductor region to the second main surface side; and an insulating layer provided between an inner wall surface of each of the plurality of through holes and each of the plurality of through hole electrodes, wherein at least a part of the inner wall surface of each of the plurality of through holes is formed to be smoother compared to the first main surface of the semiconductor substrate,

In the first aspect of the present invention, the first main surface of the semiconductor substrate and the inner wall surface of each of the plurality of through holes may be etched surfaces. Further, the first main surface of the semiconductor substrate may be a textured surface.

In the first aspect of the present invention, at least a part of the inner wall surface of each of the plurality of through holes may have an arithmetic mean roughness smaller than an arithmetic mean roughness of the first main surface of the semiconductor substrate. In addition, the first main surface of the semiconductor substrate may be a textured surface, and the inner wall surface of each of the plurality of through holes may be an etched surface.

In the first aspect of the present invention, the semiconductor substrate may be formed of single-crystalline silicon, the first main surface of the semiconductor substrate may be a (100) plane, and the inner wall surface of each of the plurality of through holes may be a (110) plane.

The first aspect of the present invention may further include a plurality of first collective electrodes each formed on a surface of the semiconductor region and each collecting photogenerated carriers collected in the semiconductor region. In this case, each of the plurality of through hole electrodes may be electrically connected to each of the plurality of first collective electrodes. Further, each of the plurality of through hole electrodes may be integrally formed with each of the plurality of first collective electrode. Moreover, the first aspect of the present invention may further include a plurality of second collective electrodes each formed on the second main surface of the semiconductor substrate and each electrically connected to each of the plurality of through hole electrodes.

In the first aspect of the present invention, the semiconductor region may be formed of amorphous semiconductor.

In the first aspect of the present invention, the first main surface may be a light-receiving surface, and the second main surface may be a back surface.

A second aspect of the present invention is summarized as a manufacturing method of a solar cell, including: forming a plurality of through holes that penetrates from a first main surface to a second main surface of a semiconductor substrate having a first conductive type; etching an inner wall surface of each of the plurality of through holes; etching the first main surface of the semiconductor substrate; forming a semiconductor region on the first main surface of the semiconductor substrate; forming each of an insulating layer on the inner wall surface of each of the plurality of through holes; and forming each of a plurality of through hole electrodes in each of the plurality of through holes, wherein the inner wall surface of each of the plurality of through holes is etched to be smoother compared to the first main surface of the semiconductor substrate.

In the second aspect of the invention, the etching of the inner wall surface may be carried out by using a first etching solution, the etching of the first main surface may be carried out by using a second etching solution, and an etching performance of the first etching solution may be higher than an etching performance of the second etching solution.

In the second aspect of the invention, in the etching of the first main surface, each of the plurality of through holes may be covered with a mask.

In the second aspect of the invention, the semiconductor substrate may be formed of single-crystalline silicon, the first main surface of the semiconductor substrate may be a (100) plane, and in forming the plurality of through holes, a (110) plane may be exposed on at least a part of the inner wall surface of each of the plurality of through holes.

In the second aspect of the invention, the semiconductor region may be formed of amorphous semiconductor.

### IN THE DRAWINGS:

Fig. 1 is a side view showing the configuration of the solar cell module according to the embodiment of the present invention.
Fig. 2 is a plan view of the solar cell module according to the embodiment of the present invention viewed from the light-receiving surface-side.
Fig. 3 is a plan view of the solar cell module according to the embodiment of the present invention viewed from the back-surface-side.
Fig. 4 is an enlarged cross-sectional view taken along line A-A of Fig. 2.
Fig. 5 is a perspective view of the n-type single-crystalline silicon 11 according to the first embodiment of the present invention viewed from the light-receiving surface-side.
Fig. 6 is a perspective view of the n-type single-crystalline silicon 11 according to the second embodiment of the present invention viewed from the light-receiving surface-side.
Fig. 7 is an enlarged cross-sectional view taken along line A-A of Fig. 2.
Fig. 8 is a perspective view of the n-type single-crystalline silicon substrate 51 according to the third embodiment of the present invention viewed from the light-receiving surface-side.
Fig. 9 is a graph showing the relationship between the value of the through hole inner wall surface Ra/the light-receiving surface Ra and the value of solar cell properties (F.F).

Embodiments of the present invention will be described with reference to the accompanying drawings. In the following description of the drawings, identical or similar constituents are designated by identical or similar reference numerals. It is to be noted, however, that the drawings are merely schematic and proportions of the dimensions and other factors are different from the reality. Therefore, it is to be understood that the concrete dimensions and the like are supposed to be determined in consideration of the following description of the invention. Moreover, as a matter of course, dimensional relations or proportions may vary among the drawings.

### 1. First Embodiment

### (Schematic Configuration of Solar Cell Module)

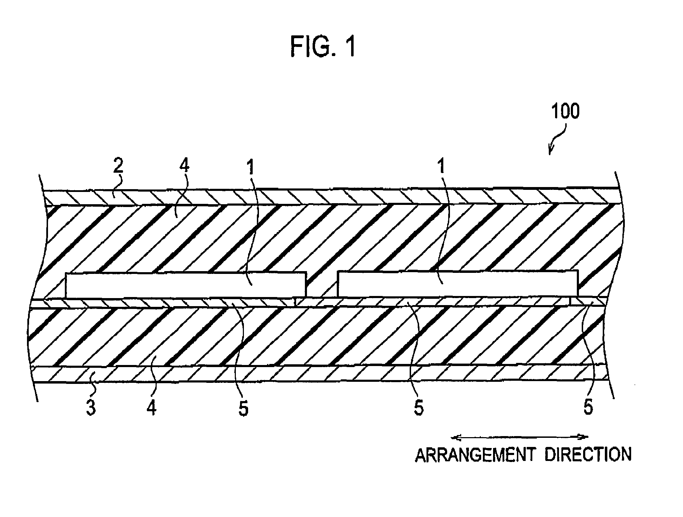

The schematic configuration of a solar cell module 100 according to the first embodiment of the present invention will be described with reference to Fig. 1. Fig. 1 is a side view showing the configuration of a solar cell module 100 according to the embodiment.

As shown in Fig. 1, a solar cell module 100 according to the embodiment includes a plurality of solar cells 1, a light-receiving-side protective member 2, a back-surface-side protective member 3, a sealing member 4, and a wiring member 5. The solar cell module 100 is formed by sealing a plurality of solar cells 1 between the light-receiving-side protective member 2 and the back-surface-side protective member 3 by using the sealing member 4.

The plurality of solar cells 1 is arranged in an arrangement direction. The plurality of solar cells 1 is electrically connected to each other through the wiring member 5. Each solar cell 1 has a light-receiving surface (upper surface in Fig.1) for receiving the sunlight, and a back surface (lower surface in Fig.1) provided opposite to the light-receiving surface. The light-receiving surface and the back surface are main surfaces of the solar cell 1. The configuration of each of the solar cell 1 will be described hereinafter.

The wiring member 5 is disposed on the back surface of the solar cell 1, and electrically connects one solar cell 1 to a different solar cell 1 adjacent to the one solar cell 1. Thus, the solar cell module 100 according to the present embodiment is a so-called a "back contact type" solar cell module. As the wiring member 5, a conductive material such as copper, which is formed either into a thin-ptate shape or into a twisted-wire shape, may be used. Here, on a surface of thin-film copper or the like used as the wiring member 5, such as eutectic solder may be plated.

The light-receiving surface-side protective member 2 is provided on a light-receiving surface of the sealing member 4 and protects an upper surface of the solar cell module 10. As the light-receiving surface-side protective member 2, a glass having transparent and water-blocking properties, transparent plastic, and the like may be used.

The back-surface-side protective member 3 is provided on the back surface of the sealing member 4, and protects a back surface of the solar cell module 10. As the back-surface-side protective member 3, a resin film such as a PET (polyethylene terephthalate) film or a laminated film having a structure in which an AI foil is sandwiched therebetween, may be used.

The sealing member 4 seals the plurality of solar cells 1 between the light-receiving surface-side protective member 2 and the back-surface-side protective member 3. Any of resins including olefin resins such as polyethylene and polypropylene, and other resins such as EVA. EEA, PVB, silicone, urethane, acryl and epoxy resins may be used as the sealing member 4.

It should be noted that an AI frame (not shown) may be attached to an outer circumference of the solar cell module 100 having the above-described configuration.

### (Configuration of Solar Cell)

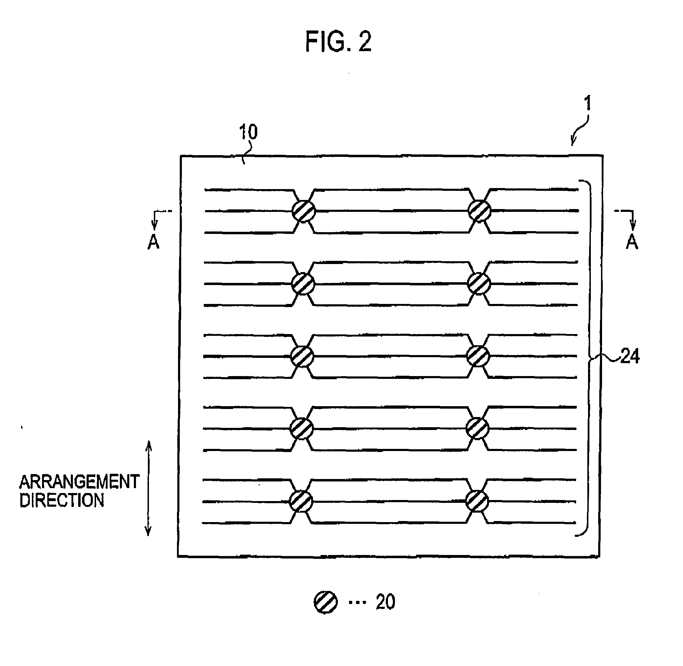

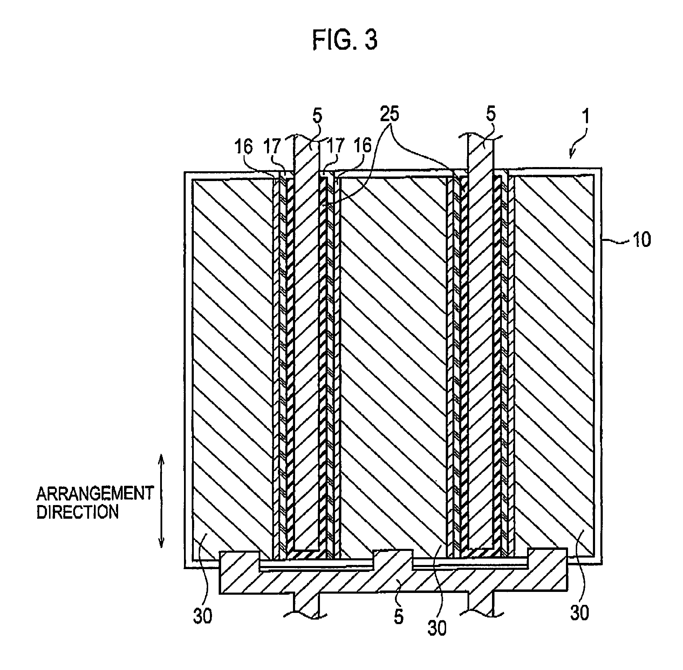

The configuration of the solar cell 1 will then be described with reference to Figs. 2 and 3. Fig. 2 is a plan view of the solar cell 1 viewed from the light-receiving surface-side. Fig. 3 is a plan view of the solar cell 1 viewed from the back-surface-side.

As shown in Fig. 2, the solar cell 1 includes a photoelectric conversion part 10, a light-receiving surface-side collective electrode 24 and a through hole electrode 20.

The photoelectric conversion part 10 has a light-receiving surface for receiving lights, and a back surface provided opposite to the light-receiving surface. The photoelectric conversion part 10 generates photogenerated carriers by use of the light received on the light-receiving surface. Here, the photogenerated carriers are referred to electron holes and electrons generated by the solar light absorbed by the photoelectric conversion part 10.

As described hereinafter, the photoelectric conversion part 10 according to the present embodiment has a structure called an HIT structure in which a substantially intrinsic amorphous silicon layer is interposed between a single crystalline silicon (semiconductor substrate) and an amorphous silicon layer (semiconductor region).

The light-receiving surface-side collective electrode 24 is an electrode for collecting photogenerated carriers generated by the photoelectric conversion part 10. In Fig. 2, multiple light-receiving surface-side collective electrodes 24 are formed substantially on the entire area on the light-receiving surface of the photoelectric conversion part 10. However, the number of the light-receiving surface-side collective electrodes 24 can be modified appropriately in consideration of the size or the like of the photoelectric conversion part 10. The light-receiving surface-side collective electrode 24 can be formed by use of a printing method using a thermosetting conductive paste, for example.

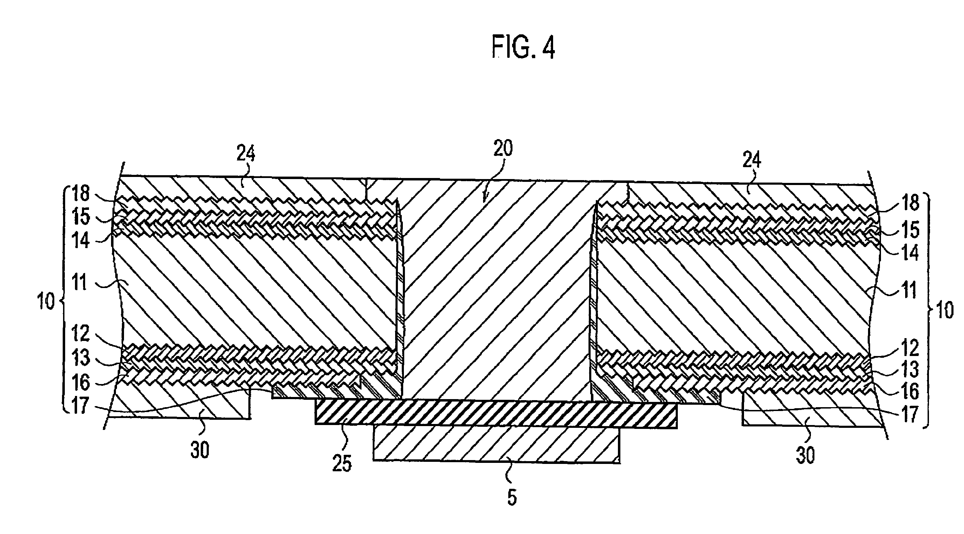

The through hole 20 is electrically connected to the light-receiving surface-side collective electrode 24, on the light-receiving surface of the photoelectric conversion part 10. The photogenerated carriers collected by the light-receiving surface-side collective electrode 24 from the photoelectric conversion part 10 are thereafter collected by the through hole electrode 20. In a single-crystalline silicon of the photoelectric conversion part 10, the plurality of through hole electrodes 20 is provided in a plurality of portions. Further, each of the plurality of through hole electrodes 20 is provided in each of the through holes (not shown in Fig. 2,refer to Fig. 4) that is penetrating from the light-receiving surface to the back surface. Therefore, the photogenerated carriers collected by the light-receiving surface-side collective electrode 24 are conducted, via each of the plurality of through hole electrodes 20, to the back-surface-side of the photoelectric conversion part 10. In the present embodiment, the photoelectric conversion part 10 has ten through hole electrodes 20, in a row of five through hole electrodes 20 along the arrangement direction (see Fig.2). However, the number of the through hole electrodes 20 is modified appropriately in consideration of the number of the light-receiving surface-side collective electrodes 24, resistance ratio of the conductive material composing each of the through hole electrodes 20, and the like. The through hole electrodes 20 can be made of a conductive material similar to the light-receiving surface-side collective electrodes 24.

As shown in Fig. 3, the solar cell 1 further includes a light-receiving surface-side bus bar electrode 25 and a back-surface-side collective electrode 30.

The light-receiving surface-side bus bar electrode 25 is an electrode for collecting photogenerated carriers from the five through hole electrodes 20 arranged in a row along the arrangement direction on the back surface of the photoelectric conversion part 10. As shown in Fig. 3, the light-receiving surface-side bus bar electrodes 25 are formed in a line along the arrangement direction. The light-receiving surface-side bus bar electrode 25 is insulated from the back-surface-side of the photoelectric conversion part 10 and the back-surface-side collective electrode 30 by an insulating layer 17 described hereinafter. The light-receiving surface-side bus bar electrode 25 can be made of a conductive material similar to the light-receiving surface-side collective electrodes 24.

The back-surface-side collective electrode 30 collects, from the photoelectric conversion part 10, photogenerated carriers having a different polarity from the photogenerated carriers collected by the light-receiving surface-side bus bar electrode 25. The back-surface-side collective electrode 30 is formed on the back surface of the photoelectric conversion part 10 in an area where the light-receiving surface-side bus bar electrode 25 is not formed. However, the present invention is not to limit the shape and the like of the collective electrode formed on the back surface of the photoelectric conversion part 10.

Here, as shown in Fig. 3, a wiring member 5 is electrically connected to the light-receiving surface-side bus bar electrode 25 of one solar cell 1 and to the back-surface-side collective electrode 30 of a different solar cell 1 adjacent to the one solar cell 1. To be more specific, one end of the wiring member 5 is disposed on the light-receiving surface-side bus bar electrode 25 along the arrangement direction. The other end of the wiring member 5 is disposed on an end, in the arrangement direction, of the back-surface-side collective electrode 30. Thereby, the solar cells 1 are electrically connected to each other.

### (Configuration of Photoelectric conversion part)

The detailed configuration of the photoelectric conversion part 10 of the solar cell 1 will then be described with reference to Fig. 4. Fig. 4 is an enlarged cross-sectional view taken along line A-A of Fig. 2.

The photoelectric conversion part 10 includes an n-type single-crystalline silicon 11, an i-type amorphous silicon layer 12, an n-type amorphous silicon layer 13, an i-type amorphous silicon layer 14, a p-type amorphous silicon layer 15, a back-surface-side transparent conductive layer 16, an insulating layer 17, and a light-receiving surface-side transparent conductive layer 18.

The n-type single-crystalline silicon 11 contains single crystal silicon as a major component and has a thickness of about 200 µm. The n-type single-crystalline silicon 11 has a light-receiving surface, a back surface provided opposite to the light-receiving surface, a plurality of through holes each penetrating from the light-receiving surface to the back surface of the n-type single-crystalline silicon 11. As shown in Fig. 4, a through hole electrode 20 is provided inside the through hole. The inner wall surface of the through hole is an etched surface formed by an etching processing. The light-receiving surface and the back surface of the n-type single-crystalline silicon 11 are a textured surface on which a fine textured structure (pyramid-like relief structure) is formed. Each of the texture has a height of several µm to several tens µm.

The i-type amorphous silicon layer 12 is formed on the back surface of the n-type single-crystalline silicon 11. The i-type amorphous silicon layer 12 has a thickness of about 5 nm and is substantially intrinsic.

The n-type amorphous silicon layer 13 is formed on the back surface of the i-type amorphous silicon layer 12 by use of a CVD method. The n-type amorphous silicon layer 13 has a thickness of about 5 nm. Here, the n-type single-crystalline silicon 11, the i-type amorphous silicon layer 12 and the n-type amorphous silicon layer 13 form a so-called BSF structure.

An i-type amorphous silicon layer 14 is formed on the light-receiving surface of the n-type single-crystalline silicon 11. The i-type amorphous silicon layer 14 has a thickness of about 5 nm and is substantially intrinsic.

A p-type amorphous silicon layer 15 is formed on the back surface of the i-type amorphous silicon layer 14 by use of a CVD method. The p-type amorphous silicon layer 15 has a thickness of about 5 nm. A semiconductor junction that generates an electric field is formed by the n-type single-crystalline silicon 11, the i-type amorphous silicon layer 14 and the p-type amorphous silicon layer 15.

A back-surface-side transparent conductive layer 16 is formed on the back surface of the n-type amorphous silicon layer 13 by use of a PVD method such as a spattering method and a vapor deposition method. The back-surface-side transparent conductive layer 16 can be formed of an oxide such as In, Zn, Sn, Ti and W.

An insulating layer 17 is provided between the inner wall surface of the through hole, which is formed in the n-type single-crystalline silicon 11, and the through hole electrode 20, while extending from the inner wall surface to the back surface of the back-surface-side transparent conductive layer 16. The insulating layer 17 insulates the n-type single-crystalline silicon 11, the i-type amorphous silicon layer 12, the n-type amorphous silicon layer 13 and the back-surface-side transparent conductive layer 16 from the through hole electrode 20. In addition, the insulating layer 17 insulates the light-receiving surface-side bus bar electrode 25 from the back-surface-side collective electrode 30. The insulating layer 17 can be formed of, for example, SiN.

A light-receiving surface-side transparent conductive layer 18 is formed on the light-receiving surface of the p-type amorphous silicon layer 15 by use of a PVD method such as a spattering method or a vapor deposition method. The light-receiving surface-side transparent conductive layer 18 can be made of a conductive material similar to the back-surface-side transparent conductive layer 16.

### (Configuration of Semiconductor Substrate)

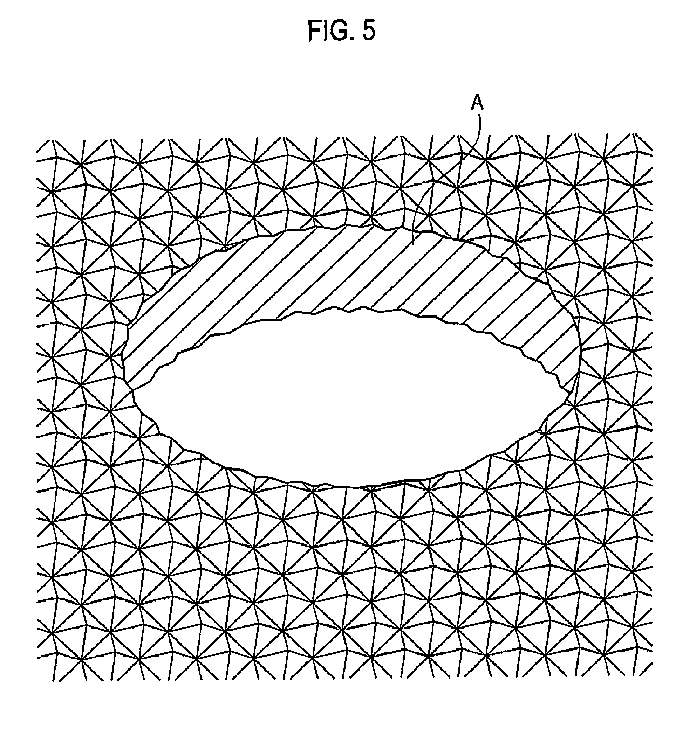

The configuration of the n-type single-crystalline silicon 11 will be described with reference to Fig. 5. Fig. 5 is a perspective view of the n-type single-crystalline silicon 11 according to the present embodiment viewed from the light-receiving surface-side.

On the light-receiving surface and the back surface of the n-type single-crystalline silicon 11, a textured structure is formed (in Fig.5, only light-receiving surface is shown). Each of the textured structure has a height of several µm to several tens µm in a direction vertical to the light-receiving surface.

In the n-type single-crystalline silicon 11, the through holes each penetrating from the light-receiving surface to the back surface are formed. Each of the through holes is formed in a circle in a plan view of the n-type single-crystalline silicon 11.

Here, the inner wall surface of the through hole is formed by a uniformly smooth surface A. Note that, on the uniformly smooth surface A, a relief structure (not shown) is formed. The relief structure formed on the uniformly smooth surface A is smaller and gentler than that of the textured structure formed on the light-receiving surface. Such a relief structure has a height (zero point several µm to several µm) of about one-tenth of that of the textured structure on the light-receiving surface.

Therefore, the inner wall surface of the through hole is formed to be smoother compared to the light-receiving surface. In other words, the arithmetic mean roughness (Ra) of the smooth surface A forming the inner wall surface of the through hole is smaller than the arithmetic mean roughness (Ra) of the light-receiving surface. Note that, the arithmetic mean roughness (Ra) is specified in conformity with Japanese Industrial Standard (JIS B 0601-1994).

### (Manufacturing method of solar cell)

A manufacturing method of a solar cell 1 according to the present embodiment will be described hereinbelow.
(1) Through Hole Formation Process
   Firstly, a plurality of through holes each having circular shapes and each penetrating the n-type single-crystalline silicon 11 from the light-receiving surface to the back surface is formed by a laser processing or a mechanical processing using a drill or sandblast and the like. For example, a YAG laser can be used in the laser processing.
(2) Rough Etching Process (First Etching Process)
   Then, a rough etching processing is performed on the surfaces (including the light-receiving surface and the back surface) of the n-type single-crystalline silicon 11 and the inner wall surface of each of the through holes. The rough etching processing according to the present embodiment is an anisotropic etching processing. For example, such an anisotropic etching process is carried out by immersing the n-type single-crystalline silicon 11 for about 10 minutes in a high concentration NaOH water solution (about 5% by weight) at about 85°C.
   By the rough etching process, process deformations formed on the surface of the n-type single-crystalline silicon 11 and the inner wall surface of the through hole can be removed. Further, the smooth surface A having a gentle relief structure is formed on the inner wall surface of the through holes. Such a relief structure each has a height of zero point several µm to several µm.
(3) Texture Process (Second Etching Process)
   Next, each of the through holes is covered with an anti-etching photoresist mask. Subsequently, the texture processing is performed on the surface of the n-type single-crystalline silicon 11. Here, the texture processing is an anisotropic etching processing carried out by immersing the n-type single-crystalline silicon 11, for example, for about 30 minutes in a low concentration (about 1.5% by weight) NaOH water solution at about 85°C. In other words, the etching performance of the etching solution used in the forgoing first etching process is higher than that of the etching solution used in the second etching process. Thereby, the inner wall surface of the through hole is formed to be smoother compared to the light-receiving surface.
   By such an anisotropic etching processing, the textured structure is formed on the surface of the n-type single-crystalline silicon 11. The textured structure each has a height of several µm to several tens µm in a direction vertical to the light-receiving surface.
(4) Semiconductor Region Formation Process
   After removing the photoresist mask covering the inner wall surface of each of the through holes, the i-type amorphous silicon layer 12 and the n-type amorphous silicon layer 13 are sequentially formed on the back surface of the n-type single-crystalline silicon 11, by using a chemical vapor deposition (CVD) method. Subsequently, the i-type amorphous silicon layer 14 and the p-type amorphous silicon layer 15 are sequentially formed on the light-receiving surface of the n-type single-crystalline silicon 11, by using a CVD method.
(5) Transparent Conductive Layer and Insulating Layer Formation Process
   Next, a mask is provided to cover the back-surface-side opening of each of the through holes and its circumference, and the back-surface-side transparent conductive layer 16 is formed on the n-type amorphous silicon layer 13. The physical vapor deposition (PVD) method such as a vapor deposition method, spattering method, an ion plating method and the like can generally be used as a method of forming a transparent conductive layer.
   Then, a mask is provided to cover the circumference of the back-surface-side opening of each of the through holes. Subsequently, the insulating layer 17 is formed in each of the through holes, by using SiO, SiN and the like by use of a CVD method. At the same time, the insulating layer 17 is formed so as to extend along the arrangement direction on the back surface of the back-surface-side transparent conductive layer 16. Then, the light-receiving surface-side transparent conductive layer 18 is formed on the p-type amorphous silicon layer 15.
(6) Electrode Formation Process
   Then, the light-receiving surface-side collective electrode 24 is formed on the light-receiving surface-side transparent conductive layer 18. Further, the back-surface-side collective electrode 30 is formed on the back-surface-side transparent conductive layer 16. Subsequently, each of the through holes is filled with the through hole electrode 20. For example, the light-receiving surface-side collective electrode 24, the back-surface-side collective electrode 30, and the through hole electrode 20 can be formed by use of a screen printing method using a thermosetting conductive paste, and vacuum vapor deposition such as a vapor deposition method, spattering method and the like. Each of the through hole electrodes 20 is insulated from the inner wall surface of the through hole by the insulating layer 17.
   Then, the light-receiving surface-side bus bar electrode 25 is formed on the insulating layer 17 and on each of the through hole electrodes 20. The light-receiving surface-side bus bar electrode 25 can be formed by use of the same method as that used for the light-receiving surface-side collective electrode 24. The light-receiving surface-side bus bar electrode 25 is insulated from the back-surface-side by the insulating layer 17.

### (Effects and Advantages)

A manufacturing method of a solar cell 1 according to the present embodiment includes a first etching process in which the inner wall surface of the through hole is anisotropically etched, and a second etching process in which the light-receiving surface is anisotropically etched. In the first etching process, the inner wall surface of the through hole is formed to be smoother compared to the light-receiving surface. To be more specific, the first etching process uses a high concentration NaOH solution (5% by weight) and the second etching process uses a low concentration NaOH solution (1.5% by weight).

Thus, according to the manufacturing method of the solar cell 1 of the present embodiment, the etching processes can be respectively performed under different conditions, on the inner wall surface of the through hole and on the light-receiving surface. Therefore, suitable etching processes for both of the inner wall surface and the light-receiving surface can be respectively performed.

To be more specific, in the first etching process, an etching rate is increased with relatively high concentration of the etching solution, so that an over-etched state is created. As a result, a gentle relief structure having a height of zero point several µm to several µm is formed on the inner wall surface of the through hole. Meanwhile, in the second etching process, a textured structure each having a height of several µm to several tens µm suitable for a solar cell is formed.

In particular, in the present embodiment, the through hole is covered with an anti-etching mask in the second etching process. Therefore, it is possible to prevent the relief structure from being formed on the inner wall surface of the through hole in the second etching process.

As described above, on the inner wall of the through hole, the smooth surface A having arithmetic mean roughness smaller than that of the light-receiving surface is formed. On such a smooth surface A, the insulating layer 17 can be formed to have uniform thickness. Accordingly, between the n-type single-crystalline silicon 11 and the through hole electrode 20 on the smooth surface A, occurrence of the short circuit can be suppressed. As a result, the output characteristics of the solar cell 1 can be improved.

### 2. Second Embodiment

The second embodiment of the present invention will be described hereinbelow. The difference between the present embodiment and the forgoing first embodiment is that a (110) plane is exposed on the inner wall surface of the through hole, in this embodiment.

In the present embodiment, the schematic configurations of the solar cell module and the solar cell are the same as in the first embodiment. Accordingly, the difference from the forgoing first embodiment will mainly be described below.

### (Configuration of Semiconductor Substrate)

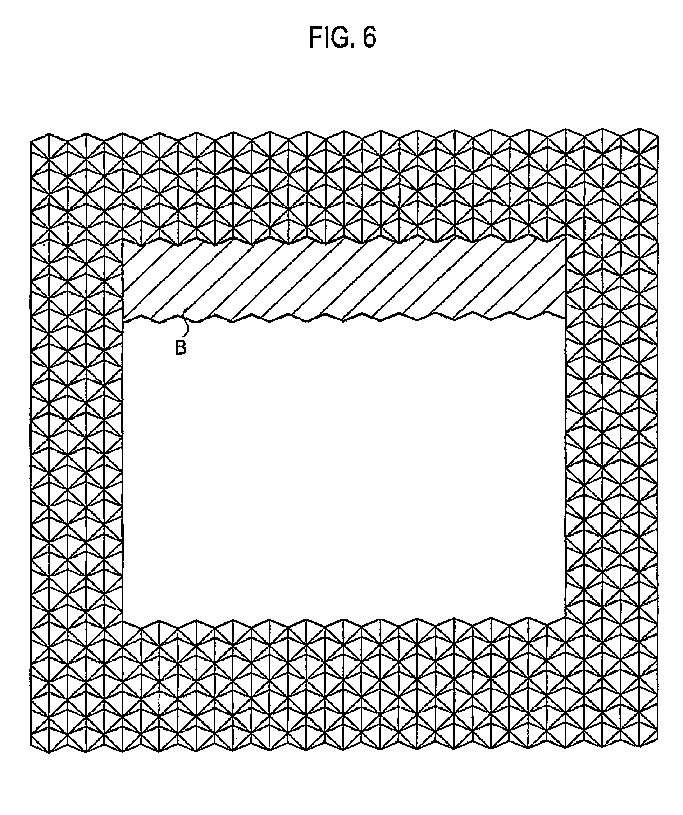

The configuration of the n-type single-crystalline silicon 11 will be described with reference to Fig. 6. Fig. 6 is a perspective view of the n-type single-crystalline silicon 11 according to the present embodiment viewed from the light-receiving surface-side.

The light-receiving surface of the n-type single-crystalline silicon 11 is a (100) plane. As shown in Fig. 6, a textured structure is formed on the light-receiving surface of the n-type single-crystalline silicon 11. Here, the textured structure formed on the light-receiving surface of the n-type single-crystalline silicon 11 each has a height of several µm to several tens µm orderly in a direction vertical to the light-receiving surface.

In the n-type single-crystalline silicon 11, a plurality of through holes is formed and each penetrates from the light-receiving surface to the back surface of the n-type single-crystalline silicon 11. Each of the through holes is formed in a substantially-quadrangular form in the planar view of the n-type single-crystalline silicon 11.

As shown in Fig. 6, the inner wall surface of the through hole is formed by four smooth surfaces B (in Fig.6, only one smooth surface B is shown). On each of the smooth surfaces B, a relief structure (not shown) is formed. The relief structure formed on the smooth surface B is smaller and gentler than that of the textured structure formed on the light-receiving surface. Such a relief structure has a height (zero point several µm to several µm) of about one-tenth of that of the textured structure of the light-receiving surface. Therefore, the inner wall surface of the through hole is formed to be smoother compared to the light-receiving surface. In other words, the arithmetic mean roughness (Ra) on the smooth surface B forming the inner wall surface of the through hole is smaller than the arithmetic mean roughness (Ra) of the light-receiving surface.

### (Manufacturing Method of Solar Cell)

A manufacturing method of a solar cell 1 according to the present embodiment will be described.
(1) Through Hole Formation Process
   Firstly, the n-type single-crystalline silicon 11, which has a (100) plane on the light-receiving surface is prepared. Then, by a laser processing or mechanical processing using such as a drill and sandblast, the substantially-quadrangular through holes each penetrating the n-type single-crystalline silicon 11 from the light-receiving surface to the back surface of the n-type single-crystalline silicon 11 are formed. Here, four smooth surfaces, which are (110) planes, are exposed on the inner wall surface of each of the through holes. For example, a YAG laser can be used in the laser processing.
   It is preferable that each of the through holes is formed in a regular square in the plan view, Such a regular square through hole can be formed by a laser processing focused on a narrowed irradiation area or by using a UV laser in which a fine processing can be performed.
(2) Rough Etching Process (First Etching Process)
   Then, a rough etching processing is performed on the surfaces (including the light-receiving surface and the back surface) of the n-type single-crystalline silicon 11 and the inner wall surface of each of the through holes. The rough etching processing according to the present embodiment is an anisotropic etching processing. For example, such an anisotropic etching processing is carried out by immersing the n-type single-crystalline silicon 11 for about 10 minutes in a high concentration NaOH water solution (about 5% by weight) at about 85°C.
   By the rough etching process, process deformations formed on the surface of the n-type single-crystalline silicon 11 and the inner wall surface of the through hole can be removed. Further, the smooth surface A having a gentle relief structure is formed on the inner wall surface of the through hole. Such a relief structure has a height of zero point several µm to several µm.
(3) Texture Process (Second Etching Process)
   Next, a texture processing is performed on the surface of the n-type single-crystalline silicon 11. Here, the texture processing is an anisotropic etching processing carried out by immersing the n-type single-crystalline silicon 11, for example, for about 30 minutes in a low concentration (about 1.5% by weight) NaOH water solution at about 85°C.
   Such an anisotropic etching processing provides the formation of the textured structure on the surface of the n-type single-crystalline silicon 11. The textured structure has a height of several µm to several tens µm in a direction vertical to the light-receiving surface.
   Incidentally, in the present embodiment, the inner wall surface of the through hole is not covered with an anti-etching photoresist mask. The smooth surface B is a (110) plane. The smooth surface B is etched at an etching rate smaller than that of the light-receiving surface. Here, the light-receiving surface is a (100) plane. Therefore, a relief structure is less likely to be formed on the smooth surface B. Consequently, the inner wall surface of the through hole is formed to be smoother compared to the light-receiving surface.
(4) Semiconductor Region Formation Process
   Then, on the back surface of the n-type single-crystalline silicon 11, the i-type amorphous silicon layer 12 and the n-type amorphous silicon layer 13 are sequentially formed, by using a chemical vapor deposition (CVD) method. Subsequently, the i-type amorphous silicon layer 14 and the p-type amorphous silicon layer 15 are sequentially formed on the light-receiving surface of the n-type single-crystalline silicon 11, by using a CVD method.
(5) Transparent Conductive Layer and Insulating Layer Formation Process
   Next, a mask Is provided to cover the back-surface-side opening of the through hole and its circumference, and the back-surface-side transparent conductive layer 16 is formed on the n-type amorphous silicon layer 13. The physical vapor deposition (PVD) method such as a vapor deposition method, spattering method, an ion plating method and the like can generally be used as a method of forming a transparent conductive layer.
   Then, a mask is provided to cover the circumference of the back-surface-side opening of the through hole. Subsequently, the insulating layer 17 is formed in each of the through holes, by using SiO, SiN and the like by use of a CVD method. At the same time, the insulating layer 17 is formed so as to extend along the arrangement direction on the back surface of the back-surface-side transparent conductive layer 16. Then, the light-receiving surface-side transparent conductive layer 18 is formed on the p-type amorphous silicon layer 15,
(6) Electrode Formation Process
   Then, the light-receiving surface-side collective electrode 24 is formed on the light-receiving surface-side transparent conductive layer 18. Further, the back-surface-side collective electrode 30 is formed on the back-surface-side transparent conductive layer 16. Subsequently, each of the through holes is filled with the through hole electrode 20. For example, the light-receiving surface-side collective electrode 24, the bark-surface-side collective electrode 30, and the through hole electrode 20 can be formed by use of a screen printing method using a thermosetting conductive paste, and vacuum vapor deposition such as a vapor deposition method, spattering method and the like. Each of the through hole electrodes 20 is insulated from the inner wall surface of the through holes by the insulating layer 17.
   The light-receiving surface-side bus bar electrode 25 is then formed on the insulating layer 17 and on each of the through hole electrodes 20. The light-receiving surface-side bus bar electrode 25 can be formed by use of the same method as that used for the light-receiving surface-side collective electrode 24. The light-receiving surface-side bus bar electrode 25 is insulated from the back-surface-side by the insulating layer 17.

### (Effects and Advantages)

A manufacturing method of a solar cell 1 according to the present embodiment includes a first etching process in which the inner wall surface of the through hole is etched, and a second etching process in which the light-receiving surface is etched. In the first etching process, the inner wall surface of the through hole is formed to be smoother compared to the light-receiving surface.

To be more specific, in the present embodiment, the light-receiving surface is a (100) plane. On the inner wall surface of the through hole, four smooth surfaces that are (110) planes are exposed. Each of the smooth surfaces B is etched at an etching rate smaller than that of the light-receiving surface. Here, the light-receiving surface is a (100) plane. Therefore, it is possible to prevent the relief structure from being formed on the inner wall surface of the through hole in the second etching process

As described above, on the inner wall of the through hole, the smooth surface B having arithmetic mean roughness smaller than that of the light-receiving surface is formed. On such a smooth surface B, the insulating layer 17 can be formed to have uniform thickness. Accordingly, between the n-type single-crystalline silicon 11 and the through hole electrode 20 on the smooth surface B, occurrence of the short circuit can be suppressed. As a result, the output characteristics of the solar cell 1 can be improved.

### 3. Third Embodiment

The third embodiment of the present invention will be described hereinbelow. The difference between the present embodiment and the forgoing first embodiment is that a semiconductor substrate mainly composed of polycrystal silicon is used in this embodiment.

In the present embodiment, the schematic configurations of the solar cell module and the solar cell are the same as in the first embodiment. Accordingly, the difference from the forgoing first embodiment will mainly be described below.

### (Configuration of Photoelectric conversion part)

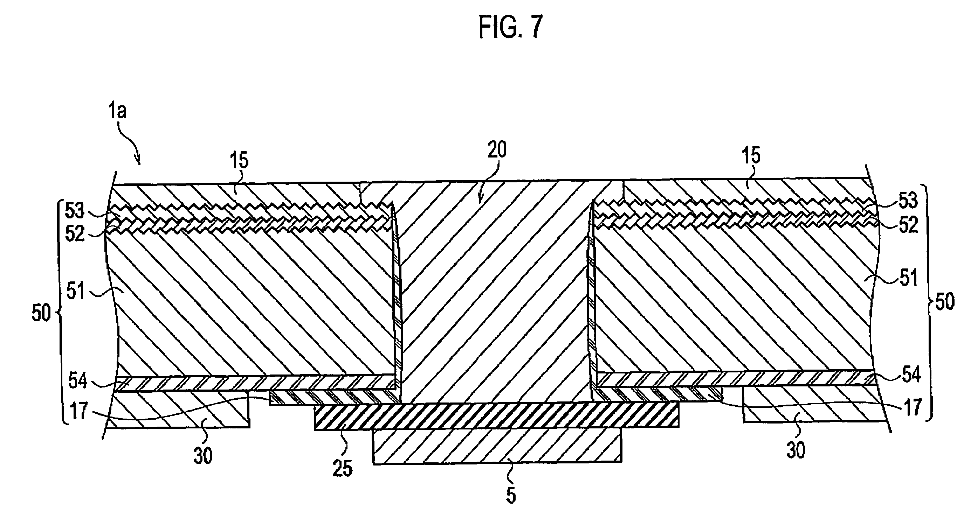

The detailed configuration of the photoelectric conversion part 50 of a solar cell 1 a according to the present embodiment will be described with reference to Fig. 7. Fig. 7 is an enlarged cross-sectional view of the solar cell 1a according to the present embodiment.

The photoelectric conversion part 50 includes an n-type polycrystalline silicon substrate 51, a p-type polycrystal silicon layer 52, an anti-reflection film 53, and n-type polycrystal silicon layer 54.

The n-type polycrystalline silicon substrate 51 is mainly composed of polycrystal silicon, and has a thickness of about 300 µm. The n-type polycrystalline silicon substrate 51 has through holes penetrating from the light-receiving surface to the back surface of the n-type polycrystalline silicon substrate 51.

As shown in Fig. 6, the through hole electrode 20 is provided inside the through hole. A fine textured structure is formed on the light-receiving surface of the n-type polycrystalline silicon substrate 51. The texture has a height of several µm to several tens µm.

The p-type polycrystal silicon layer 52 is a semiconductor layer formed by a doping of p-type impurities on the light-receiving surface of the n-type polycrystalline silicon substrate 51. The p-type polycrystal silicon layer 52 forms a semiconductor p/n junction with the n-type polycrystalline silicon substrate 51.

The anti-reflection film 53 is formed on the p-type polycrystal silicon layer 52. The anti-reflection film 53 can be formed by using SiN, SiO₂ and the like.

The n-type polycrystal silicon layer 54 is a semiconductor layer formed by a doping of n-type impurities on the back surface of the n-type polycrystalline silicon substrate 51. Thereby, a so-called BSF structure is formed.

The insulating layer 17 is provided on the inner wall surface of the through hole formed on the n-type polycrystalline silicon substrate 51, while extending from the inner wall surface to the back surface of the n-type polycrystal silicon layer 54. The insulating layer 17 insulates the n-type polycrystalline silicon substrate 51 from the through hole electrode 20. For example, the insulating layer 17 can be formed of SiN.

### (Configuration of Semiconductor Substrate)

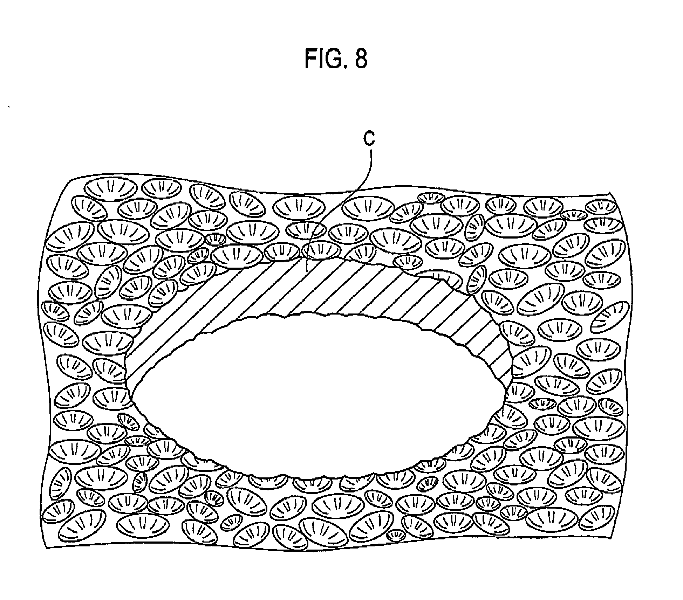

The configuration of the n-type polycrystalline silicon substrate 51 will be described with reference to Fig. 8. Fig. 8 is a perspective view of the n-type polycrystalline silicon substrate 51 according to the present embodiment viewed from the light-receiving surface-side.

On the light-receiving surface of the n-type polycrystalline silicon substrate 51A, fine texture is formed. The textured structure has a height of several µm to several tens µm in a direction vertical to the light-receiving surface.

In the n-type polycrystalline silicon substrate 51, each of the through holes penetrating from the light-receiving surface to the back surface is formed. Each of the through holes is formed in a circle form in a plan view of the n-type polycrystalline silicon substrate 51.

Here, as shown in Fig. 8, the inner wall surface of the through hole is configured by a uniformly smooth surface C. Note that, on the uniformly smooth surface C, a relief structure (not shown) is formed. The relief structure formed on the uniformly smooth surface C is smaller and gentler than that of the textured structure formed on the light-receiving surface. Such a relief structure has a height (zero point several µm to several µm) of about one-tenth of that of the textured structure on the light-receiving surface.

Therefore, the inner wall surface of the through hole is formed to be smoother compared to the light-receiving surface. In other words, the arithmetic mean roughness (Ra) of the smooth surface C forming the inner wall surface of the through hole is smaller than arithmetic mean roughness (Ra) on the light-receiving surface.

### (Manufacturing method of solar cell)

A manufacturing method of a solar cell 1a according to the present embodiment will be described.
(1) Through Hole Formation Process
   Firstly, through holes each having circular shapes and each penetrating the n-type polycrystalline silicon substrate 51 from the light-receiving surface to the back surface are formed by a laser processing or a mechanical processing using a drill or sandblast and the like. For example, a YAG laser can be used in the laser processing.
(2) Rough Etching Process (First Etching Process)
   Then, a rough etching processing is performed on the surfaces (including the light-receiving surface and the back surface) of the n-type polycrystalline silicon substrate 51 and the inner wall surface of each of the through holes. The rough etching processing according to the present embodiment is an anisotropic etching processing. For example, such an anisotropic etching processing is carried out by immersing the n-type polycrystalline silicon substrate 51 for about 10 minutes in fluorinated nitrate solution prepared by mixing 69.5% nitric acid (HNO₃) and 49% hydrofluoric acid (HF) in a ratio of 10:1.
   By the rough etching process, process deformations formed on the surface of the n-type polycrystalline silicon substrate 51 and the inner wall surface of the through hole can be removed. Further, the smooth surface C having a gentle relief structure is formed on the inner wall surface of the through hole. Such a relief structure each has a height of zero point several µm to several µm,
(3) Texture Process (Second Etching Process)
   Next, each of the through holes is covered with an anti-etching photoresist mask. Subsequently, the texture processing is performed on the surface of the n-type polycrystalline silicon substrate 51. Here, the texture processing according to the present embodiment is an isotropic etching processing. Such an isotropic etching processing is carried out by immersing the n-type polycrystalline silicon substrate 51, for example, for about 30 minutes in fluorinated nitrate solution prepared by mixing 69.5% nitric acid (HNO₃) and 49% hydrofluoric acid (HF) in a ratio of 1:5 to 15.
   By the texture processing, a textured structure can be formed on the n-type polycrystalline silicon substrate 51. The textured structure each has a height of several µm to several tens µm in a direction vertical to the light-receiving surface.
(4) Semiconductor Layer Region Formation Process and Anti-Reflection Film Formation Process
   After removing a photoresist mask covering the inner wall surface of the through hole, p-type impurities are then diffused on the light-receiving surface of the n-type polycrystalline silicon substrate 51 by using a vapor phase diffusion method, a coating diffusion method or the like. Thereby, the p-type polycrystal silicon layer 52 is formed.
   Then, on the p-type polycrystal silicon layer 52, an anti-reflection layer 53 made of SiN, SiO, and the like is formed.
   Sequentially, n-type impurities are diffused on the back surface of the n-type polycrystalline silicon substrate 51 by using a vapor phase diffusion method, a coating diffusion method, or the like. Thereby, an n-type polycrystal silicon layer 54 is formed.
(5) Transparent Conductive Layer and Insulating Layer Formation Process
   Then, a mask is provided at the circumference of the back-surface-side opening of each of the through holes. Subsequently, the insulating layer 17 is formed in each of the through holes, by using SiO, SiN and the like by use of a CVD method. At the same time, the insulating layer 17 is formed so as to extend along the arrangement direction on the back surface of the n-type polycrystal silicon layer 54..
(6) Electrode Formation Process
   Then, the light-receiving surface-side collective electrode 24 is formed on the anti-reflection layer 53. Further, the back-surface-side collective electrode 30 is formed on the back-surface-side transparent conductive layer 16. Subsequently, each of the through holes is filled with the through hole electrode 20. For example, the light-receiving surface-side collective electrode 24, the back-surface-side collective electrode 30, and the through hole electrode 20 can be formed by performing a screen printing by use of a silver paste containing Ag, a binder and frit, and thereafter performing a sintering processing. Each of the through hole electrodes 20 is insulated from the inner wall surface by the insulating layer 17.
   The light-receiving surface-side bus bar electrode 25 is then formed on the insulating layer 17 and the through hole electrode 20. The light-receiving surface-side bus bar electrode 25 can be formed by use of the same method as that used for the light-receiving surface-side collective electrode 24. The light-receiving surface-side bus bar electrode 25 is insulated from the back-surface-side by the insulating layer 17.

### (Effects and Advantages)

A manufacturing method of a solar cell 1 a according to the present embodiment includes a the first etching process in which the inner wall surface of the through hole is isotropically etched, and the second etching process in which the light-receiving surface is isotropically etched. In the first etching process, the inner wall surface of the through hole is formed to be smoother compared to the light-receiving surface.

To be more specific, in the present embodiment, the first etching process uses a fluorinated nitrate solution prepared by mixing 69.5% nitric acid (HNO₃) and 49% hydrofluoric acid (HF) in a ratio of 10:1, and the second etching, process uses a fluorinated nitrate solution prepared by mixing 69.5% nitric acid (HNO₃) and 49% hydrofluoric acid (HF) in a ratio of 1:5 to 15.

Thus, according to the manufacturing method of the solar cell 1a of the present embodiment, the etching processes can be respectively performed under different conditions, on the inner wall surface of the through hole and on the light-receiving surface. Therefore, suitable etching processes for both of the inner wall surface of the through hole and the light-receiving surface can be respectively performed.

To be more specific, in the first etching process, an etching rate is increased with relatively high concentration of the etching solution, so that an over-etched state is created. As a result, a gentle relief structure having a height of zero point several µm to several µm is formed on the inner wall surface of the through hole. Meanwhile, in the second etching process, a textured structure having a height of several µm to several tens µm suitable for a solar cell is formed.

In particular, in the present embodiment, the through hole is covered with an anti-etching mask in the second etching process. Therefore, it is possible to prevent a relief structure from being formed on the inner wall surface of the through hole in the second etching process. Thus, the inner wall surface of the through hole is formed to be smoother compared to the light-receiving surface.

As described above, the smooth surface C having arithmetic mean roughness smaller than that of the light-receiving surface is formed on the inner wall of the through hole, On such a smooth surface C, the insulating layer 17 can be formed to have uniform thickness. Accordingly, between the n-type polycrystalline silicon substrate 51 and the through hole electrode 20 on the smooth surface C, occurrence of the short circuit can be suppressed As a result, the output characteristics of the solar cell 1a can be improved.

### (Other Embodiments)

The present invention allows various modifications within a scope not departing the forgoing subject matter of the present invention. The description and drawings being a part of the disclosure does not limit the present invention.

For example, in the forgoing embodiments, silicon substrates having an n-conductivity type (n-type single-crystalline silicon 11, n-type polycrystalline silicon substrate 51) are used, while a silicon substrate having a p-conductivity type may be used.

Also, in the forgoing embodiments, although the same kinds of etching solutions are used in the first and second etching processes, different kinds of etching solutions may be used in each etching process. The present invention does not specify the etching solution used in the first and second etching process. In other words, the etching solution used in the first etching process only needs to have an etching performance higher than that of the etching solution used in the second etching process.

Furthermore, in the forgoing third embodiment, isotropic etching is carried out in the first and second etching processes, while anisotropic etching may be carried out.

In the forgoing embodiments, although an aspect where the entire inner wall surface of the through hole is made smooth is described, the effect of the present invention can be obtained if a smooth surface is formed in at least a part of the inner wall surface of the through hole.

In the forgoing embodiments, an HIT type solar cell is given as an example to describe a solar cell, while the present invention can be applied to a general solar cell substrate in which p/n, p/i/n, i/n, or i/p semiconductor junction is formed.

### EXAMPLES

Examples are hereinafter given to specifically describe the solar cell according to the present invention. The present invention is not limited to the examples shown below, and can be suitably changed to be implemented within the scope not changing the subject matter.

### (Examples 1)

Firstly, an n-type single-crystalline silicon substrate was prepared. Then, a plurality of through holes was formed in the n-type single-crystalline silicon substrate by using a YAG laser.

Subsequently, an anisotropic etching process was performed on the surface of the n-type single-crystalline silicon substrate and the inner wall surface of each of the through holes, for 10 minutes using a high concentration NaOH water solution (about 5% by weight) at about 85°C.

Next, each of the through holes was covered with an anti-etching photoresist mask. Subsequently, an anisotropic etching process was performed on the surface of the n-type single-crystalline silicon substrate, for 30 minutes using a low concentration NaOH water solution (about 1.5% by weight) at about 85°C.

Then, the photoresist mask covering the inner wall surface of each of the through holes was removed. Subsequently, an i-type amorphous silicon layer, an n-type amorphous silicon layer, and an ITO layer were formed on the back surface of the n-type single-crystalline silicon substrate by using a chemical vapor deposition (CVD) method. In the same manner, the i-type amorphous silicon layer, the p-type amorphous silicon layer, and the ITO layer were formed on the light-receiving surface of the n-type single-crystalline silicon substrate by using a chemical vapor deposition (CVD) method.

Then, a mask was provided at the circumference of the back-surface-side opening of each of the through holes to form an insulating layer in each of the through holes, by using SiO, SiN and the like by use of a CVD method. Here, the insulating layer was formed on the back surface while extending along the arrangement direction.

Then, a thermosetting conductive paste was formed in a predetermined pattern in the ITO layer on the light-receiving surface-side and the back-surface-side by using a screen printing method. Further, a thermosetting conductive paste was formed in a predetermined pattern on the back surface of the insulating layer.

### (Example 2)

Firstly, an n-type single-crystalline silicon substrate, which was a (100) plane, was prepared. Then, a plurality of through holes was formed in the n-type single-crystalline silicon substrate by using a YAG laser. The through hole was formed in a roughly quadrangular form in its plan view to expose a (110) plane on the inner wall of the through hole.

Then, an anisotropic etching processing was performed on the surface of the n-type single-crystalline silicon substrate and the inner wall surface of each of the through holes, for 10 minutes by using a high concentration NaOH water solution (about 5% by weight) at about 85°C.

Then, an anisotropic etching processing (texture processing) was performed on the surface of the n-type single-crystalline silicon substrate, for 40 minutes by using a low concentration NaOH water solution (about 1.5% by weight) at about 85°C.

Next, the i-type amorphous silicon layer, the n-type amorphous silicon layer, and the ITO layer were formed on the back surface of the n-type single-crystalline silicon substrate by using a chemical vapor deposition (CVD) method. In the same manner, the i-type amorphous silicon layer, the p-type amorphous silicon layer, and the ITO layer were formed on the light-receiving surface of the n-type single-crystalline silicon substrate.

Then, a mask was provided at the circumference of the back-surface-side opening of each of the through holes to form an insulating layer in the through hole using SiO, SiN and the like by use of a CVD method. Here, an insulating layer was formed on the back surface while extending along the arrangement direction.

Then, a thermosetting conductive paste was formed in a predetermined pattern on the light-receiving surface-side and on the back-surface-side of the ITO layer, by using a screen printing method. A bus bar electrode was formed in a predetermined pattern on the back-surface-side of the insulating layer,

### (Prior Example)

In the prior example, the through holes were not formed previously in the n-type single-crystalline silicon substrate. Here, the through holes were formed by using a YAG laser after the solar cell substrate was formed. An etching processing was not performed on the inner wall surface of each of the through holes. Other processes were the same as in the forgoing example 1.

### (Arithmetic Mean Roughness and Solar Cell Characteristics)

With respect to Example 1, Example 2 and the prior example, the arithmetic mean roughness (Ra) on the light-receiving surface and the arithmetic mean roughness (Ra) on the inner wall surface of the through hole were measured. A laser microscope VK-970 available from Keyence Corporation was used to measure the arithmetic mean roughness (Ra) to calculate an average value in ten portions of each surface. The Ra was calculated by averaging the absolute values of the heights of irregularities over a reference length.

With respect to the Example 1, Example 2, and prior example, various characteristics of each solar cell were measured.

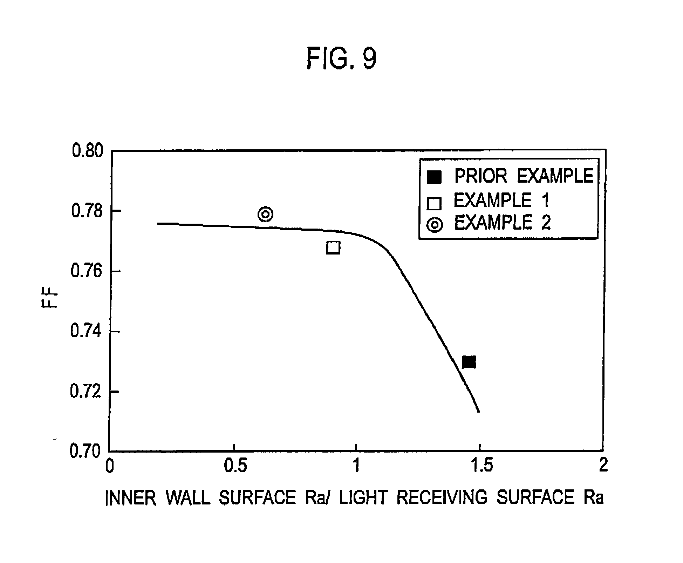

The above results are shown in Table 1. Fig. 9 shows the relationship between the value of an inner wall surface Ra/a light-receiving surface Ra and the value of solar cell characteristics (F. F).

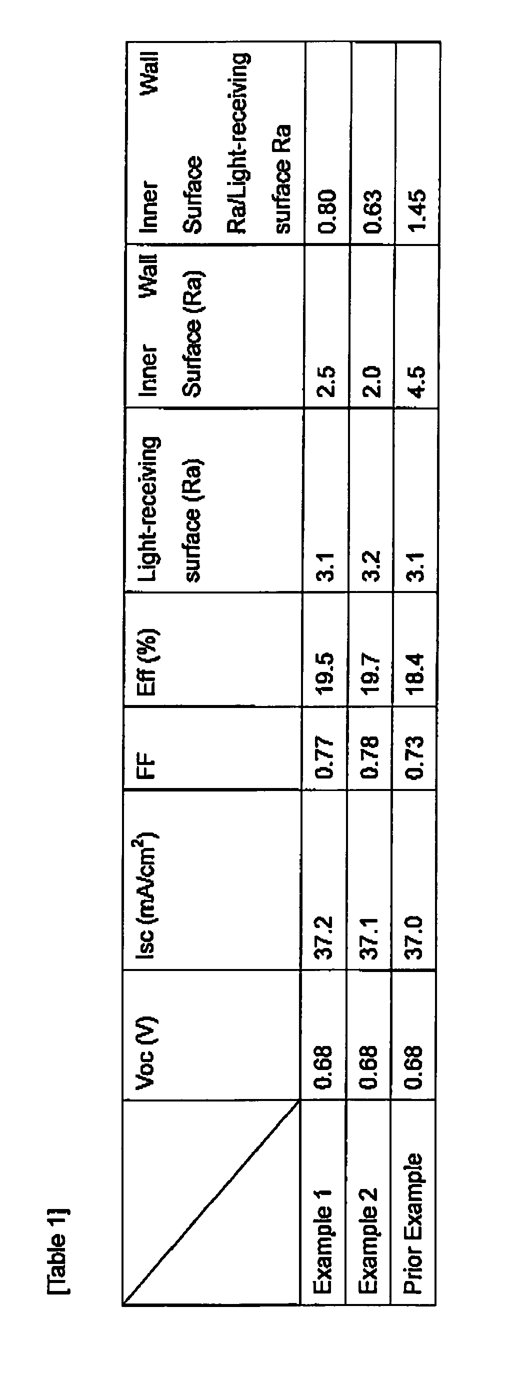

As shown in Table 1, the value of Inner Wall Surface (Ra)/Light-receiving surface (Ra) according to Examples 1 and 2 is smaller than the value of Inner Wall Surface (Ra)/Light-receiving surface (Ra) according to the Prior Example, and smaller than 1.00. This indicates that the inner wall surface of the through hole is smoothened in Examples 1 and 2. Thus, in the Examples 1 and 2, the insulating layer is uniformly formed on the inner wall of the through hole. This uniformly formed insulating layer makes it possible to prevent an occurrence of a leak current between the through hole electrode and the substrate. As a result, as shown in the above table, the F. F value according to Examples 1 and 2 is larger than the F. F value according to Prior Example.

When the value of Inner wall surface (Ra)/Light-receiving surface (Ra) is smaller than 1.0 as shown in Fig. 9, the aforementioned effect can be obtained. In other words, when the arithmetic mean roughness of the inner wall of the through hole is smaller than the arithmetic mean roughness of the light-receiving surface of the substrate, in particular, the aforementioned effect is obtained.

It has been confirmed from the forgoing result that when the inner wall surface of the through hole has an arithmetic mean roughness smaller than that on the light-receiving surface of the n-type single-crystalline silicon substrate, solar cell characteristics can be improved.

## Claims

1. A solar cell, comprising:
a semiconductor substrate having a first conductive type and including a first main surface and a second main surface;
a semiconductor region having a second conductive type and provided on the first main surface of the semiconductor substrate;
a plurality of through holes each provided in a plurality of portions in the semiconductor substrate and each penetrating from the first main surface to the second main surface;
a plurality of through hole electrodes each provided in each of the plurality of through holes and each conducting photogenerated carriers collected in the semiconductor region to the second main surface side; and
an insulating layer provided between an inner wall surface of each of the plurality of through holes and each of the plurality of through hole electrodes, wherein
at least a part of the inner wall surface of each of the plurality of through holes is formed to be smoother compared to the first main surface of the semiconductor substrate.

2. The solar cell according to claim 1, wherein the first main surface of the semiconductor substrate and the inner wall surface of each of the plurality of through holes are etched surfaces.

3. The solar cell according to claim 2, wherein the first main surface of the semiconductor substrate is a textured surface.

4. The solar cell according to claim 1, wherein at least a part of the inner wall surface of each of the plurality of through holes has an arithmetic mean roughness smaller than an arithmetic mean roughness of the first main surface of the semiconductor substrate.

5. The solar cell according to claim 4, wherein
the first main surface of the semiconductor substrate is a textured surface, and
the inner wall surface of each of the plurality of through holes is an etched surface.

6. The solar cell according to claim 1, wherein
the semiconductor substrate is formed of single-crystalline silicon,
the first main surface of the semiconductor substrate is a (100) plane, and
the inner wall surface of each of the plurality of through holes is a (110) plane.

7. The solar cell according to claim 1, further comprising:
a plurality of first collective electrodes each formed on a surface of the semiconductor region and each collecting photogenerated carriers collected in the semiconductor region, wherein
each of the plurality of through hole electrodes is electrically connected to each of the plurality of first collective electrodes.

8. The solar cell according to claim 7, wherein each of the plurality of through hole electrodes is integrally formed with each of the plurality of first collective electrode.

9. The solar cell according to claim 7, further comprising a plurality of second collective electrodes each formed on the second main surface of the semiconductor substrate and each electrically connected to each of the plurality of through hole electrodes.

10. The solar cell according to claim 1, wherein the semiconductor region is formed of amorphous semiconductor.

11. The solar cell according to claim 1, wherein the first main surface is a light-receiving surface, and the second main surface is a back surface.

12. A manufacturing method of a solar cell, comprising:
forming a plurality of through holes that penetrates from a first main surface to a second main surface of a semiconductor substrate having a first conductive type;
etching an inner wall surface of each of the plurality of through holes;
etching the first main surface of the semiconductor substrate;
forming a semiconductor region on the first main surface of the semiconductor substrate;
forming an insulating layer on the inner wall surface of each of the plurality of through holes; and
forming each of a plurality of through hole electrodes in each of the plurality of through holes, wherein
the inner wall surface of each of the plurality of through holes is etched to be smoother compared to the first main surface of the semiconductor substrate.

13. The manufacturing method of the solar cell according to claim 12, wherein
the etching of the inner wall surface is carried out by using a first etching solution,
the etching of the first main surface is carried out by using a second etching solution, and
an etching performance of the first etching solution is higher than an etching performance of the second etching solution.

14. The manufacturing method of the solar cell according to claim 12, wherein, in the etching of the first main surface, each of the plurality of through holes is covered with a mask.

15. The manufacturing method of the solar cell according to claim 12, wherein
the semiconductor substrate is formed of single-crystalline silicon,
the first main surface of the semiconductor substrate is a (100) plane, and
in forming the plurality of through holes, a (110) plane is exposed on at least a part of the inner wall surface of each of the plurality of through holes.

16. The manufacturing method of the solar cell according to claim 15, wherein the semiconductor region is formed of amorphous semiconductor.

17. A solar cell, comprising:
a single-crystalline silicon substrate having a first conductive type and including a first main surface and a second main surface;
a semiconductor region having a second conductive type and provided on the first main surface of the single-crystalline silicon substrate;
a plurality of through holes each provided in a plurality of portions in the single-crystalline silicon substrate and each penetrating from the first main surface to the second main surface;
a plurality of through hole electrodes each provided in each of the plurality of through holes and each conducting photogenerated carriers collected in the semiconductor region to the second main surface side; and
an insulating layer provided between an inner wall surface of each of the plurality of through holes and each of the plurality of through hole electrodes, wherein
the first main surface of the single-crystalline silicon substrate is a (100) plane, and
the inner wall surface of each of the plurality of through holes is a (110) plane.

18. The solar cell according to claim 17, wherein the semiconductor region is formed of amorphous semiconductor.
